# EUROPEAN PATENT APPLICATION

(11) **EP 3 951 841 A1**
(43) Date of publication of application: **09.02.2022**
(21) Application number: 20190109.7
(22) Date of filing: 07.08.2020
(51) Int. Cl.: H01L 21/56, H01L 23/31, H01L 29/06, H01L 23/24

(54) **POWER SEMICONDUCTOR DEVICES WITH EDGE TERMINATION AND METHOD OF MANUFACTURING THE SAME**

(71) Applicant: Hitachi Energy Switzerland AG, 5400 Baden (CH)
(72) Inventor: Beyer, Harald, 5600 Lenzburg (CH); Guillon, David, 8857 Vorderthal (CH); Ehrbar, Roman, 8037 Zürich (CH)
(74) Representative: Epping - Hermann - Fischer

(57) **Abstract**

A power semiconductor device (60), which comprises a semiconductor die (10a) comprising at least one active region (AR) surrounded by an edge termination region (TR), and a method for manufacturing such power semiconductor device (60) are provided. A mold compound pattern portion (40p) is arranged on the first side (11') such that it overlaps the edge termination region (TR) in an orthogonal projection onto a plane parallel to the first side (11'). A circumferential lateral surface portion (45) of the mold compound pattern portion (40p) and a circumferential lateral surface portion (15) of the semiconductor die (10a) are both at least a part of a continuous lateral surface portion (65) of the power semiconductor device (60), wherein the continuous lateral surface portion (65) extends along a lateral circumference of the power semiconductor device (60) and has an inclination angle (α) relative to a plane parallel to the first side (11') in a range between 80° and 100°, or in a range between 85° and 95°.

## Description

### FIELD OF THE INVENTION

The present invention relates to a power semiconductor device with a mold compound pattern portion for protecting an edge termination region of the power semiconductor device, and to a method for manufacturing a plurality of such power semiconductor devices.

### BACKGROUND OF THE INVENTION

The edge termination of power semiconductor devices like insulated gate bipolar transistors (IGBTs) and power metal-oxide-semiconductor field-effect transistors (MOSFETs), but also power diodes is a critical feature especially in high voltage applications. When applying high voltage to a power semiconductor device in the blocking state, high electrical field strengths occur at the edge termination. Consequently, the edge termination of the power semiconductor device, but also an electrically insulating encapsulation near the edge termination must provide a very high dielectric strength to prevent partial discharge and finally dielectric breakdown resulting in a failure of a power module comprising the semiconductor device.

Because of the exposal of the edge termination to very high electrical field strengths, there are very high requirements to the robustness and the reliability of this part of the power semiconductor devices. Here, the reliability and the long-term dielectric strength of the edge termination is not only affected by operation of the power semiconductor device and the corresponding high electric field strengths itself. Reliability and long-term stability are also severely endangered by particles, humidity or hazardous gases, when getting in contact with the edge termination. So e.g. the adhesion of a polyimide film is strongly reduced, when exposed to humidity.

In recent high voltage power modules, the complete module structure comprising one or more power semiconductor devices is embedded into dielectric gel, which is filled into a cavity formed by a housing frame. There is no further barrier to prevent humidity or hazardous gases from penetration into the power module. Otherwise, humidity and atoms or molecules of hazardous substances can easily penetrate through the dielectric gel to the power semiconductor devices, where they can accommodate near critical module parts like the edge termination.

In addition to the impact of strong electric fields, gases and humidity, also a mechanical impact of the surrounding encapsulation especially in molded power packages must be considered.

From US 2015/0171026 A1 it is known a method for producing a semiconductor apparatus having a power semiconductor device, the method comprising a step of providing a silicon carbide wafer with a plurality of semiconductor devices, wherein each semiconductor device is provided with an electrode layer, respectively. The silicon carbide wafer is cut at a region of an exposed surface of the silicon carbide wafer that separates the electrode layers to individually separate the semiconductor devices (singulation). A stress relaxation resin is applied to each individually separated semiconductor device to cover the exposed surface at a peripheral end portion of that surface of the semiconductor device which has the electrode layer thereon. A semiconductor apparatus can thus be obtained that allows a semiconductor device with a silicon carbide or similar compound semiconductor die to adhere to a sealant resin via large adhesive strength and thus allows the sealant resin to be less crackable, less peelable and the like by thermal stress caused in operation. This known method has the disadvantage that it requires many individual method steps to form a protection through a sealant formed on each semiconductor device individually after singulation. Also, during singulation of the plural semiconductor devices the edge termination is not protected efficiently against mechanical damage, humidity, hazardous gases and particles, because the sealant resin is formed on the semiconductor devices only after singulation of the plural power semiconductor devices.

From EP 2 019 423 A2 it is known a modular power module consisting of a plurality of molded power package bodies arranged on a common lead frame. The individual package, independently of the assembly of components, has an electrically insulating component casing with an external geometrical form and uniform dimension. In a method for manufacturing the plurality of molded power package bodies a plurality of power semiconductor devices are arranged on a carrier foil and packaged thereafter. Before packaging the plural semiconductor devices arranged on the carrier foil, the respective edge termination regions of the plural semiconductor devices are not protected efficiently and prone to mechanical damage. Also, particles, humidity and hazardous gases may reach the edge termination, thereby impairing long-term stability and reliability of the devices.

### SUMMARY OF THE INVENTION

In view of the above disadvantages in the prior art it is an object of the invention to provide a power semiconductor device comprising an edge termination region laterally surrounding an active region, wherein a reliability and long-term stability of the power semiconductor device are improved.

The object of the invention is attained by a power semiconductor device according to claim 1. Further developments of the invention are specified in the dependent claims.

A power semiconductor device according to claim 1 comprises a semiconductor die and a mold compound pattern portion, wherein the semiconductor die has a first side and a second side opposite to the first side. The semiconductor die comprises at least one active region, each one of the at least one active region being laterally surrounded by an edge termination region, wherein laterally relates to a lateral direction parallel to the first side. The mold compound pattern portion is arranged on the first side such that it overlaps the edge termination region in an orthogonal projection onto a plane parallel to the first side. A circumferential lateral surface portion of the mold compound pattern portion is aligned with a circumferential lateral surface portion of the semiconductor die, wherein the circumferential lateral surface portion of the mold compound pattern portion and the circumferential lateral surface portion of the semiconductor die are both at least a part of a continuous lateral surface portion of the power semiconductor device, wherein the continuous lateral surface portion extends along a lateral circumference of the power semiconductor device and has an inclination angle relative to a plane parallel to the first side in a range between 80° and 100°, or in a range between 85° and 95°.

Therein, the circumferential lateral surface portion of the mold compound pattern portion is understood as being aligned with the circumferential lateral surface portion of the semiconductor die at least when, in an orthogonal projection onto a plane parallel to the first side, a (lateral) distance between a lower edge of the circumferential lateral surface portion of the mold compound pattern portion and an upper edge of the circumferential lateral surface portion of the semiconductor die is less than 2 µm or less than 1 µm. Therein, the lower edge of the circumferential lateral surface portion of the mold compound pattern portion is an edge of the circumferential lateral surface portion of the mold compound pattern portion towards the first side, and the upper edge of the circumferential lateral surface portion of the semiconductor die is a ring-shaped line where the circumferential lateral surface portion of the semiconductor die is connected to the first side.

In the power semiconductor device according to claim 1 the edge termination regions are protected by the mold compound pattern on the first side of the semiconductor die. This is a most efficient protection of the edge termination region against mechanical damage, against humidity and hazardous gases, and also against particles. Due to the alignment of the circumferential lateral surface portion of the mold compound pattern portion with the circumferential lateral surface portion of the semiconductor die, the mold compound pattern portion can protect the edge termination region up to a circumferential edge of the power semiconductor device resulting in an improved long-term stability and reliability of the thereby manufactured power semiconductor devices. Also, such mold compound pattern can be formed and protect the edge termination even before singulation of individual power semiconductor devices from a semiconductor wafer.

In an exemplary embodiment the semiconductor die comprises only one single active region laterally surrounded by only one single edge termination region. In another exemplary embodiment the semiconductor die comprises a plurality of active regions, wherein each one of the plurality of active regions is laterally surrounded and separated from the other ones of the plurality of active regions by at least one of the edge termination regions.

It is also an object of the invention to provide a molded power package with improved reliability and long-term stability. This object is attained by a molded power package according to claim 4, which comprises the power semiconductor device according to any one of the above specified exemplary embodiments. Using different materials for the first molding material and the second molding material allows for further optimization of the protection of the edge termination. For example, the first molding material may be optimized to provide protection against impurities such as humidity and hazardous gases, while the second molding material may be optimized to provide most efficient protection against mechanical damage. In another exemplary embodiment, the first molding material may have a higher dielectric strength than the second molding material. However, the invention is not limited to molded power packages in which the first molding material and the second molding material are different.

It is also an object to provide a power module with improved reliability and long-term stability. This object is attained by a power module according to claim 5, which comprises the power semiconductor device according to any one of the above specified exemplary embodiments. In this power module the whole device including the edge termination region is further protected by the dielectric gel or epoxy material.

It is also an object to provide a method for manufacturing plural power semiconductor devices with improved reliability and long-term stability, and wherein the method can avoid mechanical damage to a circumferential edge of the individual power semiconductor device. This object is attained by a method according to claim 6. Further developments of the invention are specified in the dependent claims.

In the method according to claim 6 the edge termination regions are efficiently protected by the mold compound pattern on the first main side of the semiconductor wafer. This is a most efficient protection of the edge termination region against mechanical damage, against humidity and hazardous gases, and against particles already before and during the step of separating the semiconductor wafer and the mold compound pattern into plural power semiconductor devices (singulation). This results in improved long-term stability and reliability of the thereby manufactured power semiconductor devices. For example, during the singulation the lateral edge of the individual power semiconductor devices are efficiently protected against mechanical damage such as edge breakouts.

The method according to claim 6 is also more cost efficient than a known method for manufacturing plural semiconductor devices in which an edge termination region of the individual power semiconductor devices is protected by a mold compound pattern or package formed only after singulation, because on a wafer-level a mold compound pattern on the edge termination region of each power semiconductor device can be formed simultaneously in one single molding step.

In an exemplary embodiment an electrode layer is formed on the first main side to cover at least a portion of each active region before the step of forming the mold compound pattern, and the mold compound pattern exposes at least a portion of the electrode layer on each active region. In this exemplary embodiment the exposed portion of the electrode layer can be contacted easily also after forming the mold compound pattern. In the orthogonal projection onto a plane parallel to the second main side the termination regions may not overlap with a contact area between the electrode layer and the semiconductor wafer (wherein the contact area is the area of the interface between the electrode layer and the semiconductor wafer). The mold compound pattern may expose the electrode layer either in the whole active region (when viewed in a direction perpendicular to the first main side) or only partially, i.e. only a part of the electrode layer in the active region may be exposed.

In an exemplary embodiment the mold compound pattern is a continuous layer comprising a plurality of openings, each one of the plurality of openings exposing the portion of the electrode layer on each active region. Forming the mold compound pattern as a continuous layer facilitates manufacturing of the mold compound pattern and provides the most effective protection of the semiconductor wafer against impurities and particles. The mold compound pattern may cover the whole semiconductor wafer except areas exposed through the openings and possibly except an edge exclusion area directly adjacent a circumferential edge of the semiconductor wafer which is not used for the power semiconductor devices.

In an exemplary embodiment the method for manufacturing a plurality of power semiconductor devices comprises a step of forming a passivation layer on the first main side in areas of the edge termination region before the step of forming the mold compound pattern. The passivation layer makes the semiconductor surface inert, reduces the density of surface defects and provides a more efficient protection of the edge termination region in combination with the mold compound pattern.

In an exemplary embodiment the mold compound pattern is formed by molding or transfer molding. Molding and exemplarily transfer molding are efficient means to form a thick protection layer of the mold compound pattern on the edge termination region and provide for a most efficient protection of the edge termination region, thereby improving reliability and long-term stability of the power semiconductor devices. Transfer molding is a particular versatile molding method and can fabricate products with high precision and embedded objects such as the semiconductor wafer in the present exemplary embodiment.

In an exemplary embodiment, after the step of separating the semiconductor wafer and the mold compound pattern into plural power semiconductor devices, each one of the plural power semiconductor devices comprises a semiconductor die and a mold compound pattern portion, wherein the semiconductor die is a portion of the semiconductor wafer and the mold compound pattern portion is a portion of the mold compound pattern, wherein a circumferential lateral surface portion of the mold compound pattern portion is aligned with a circumferential lateral surface portion of the semiconductor die, wherein the circumferential lateral surface portion of the mold compound pattern portion and the circumferential lateral surface portion of the semiconductor die are both at least a part of a continuous lateral surface portion of the power semiconductor device, wherein the continuous lateral surface portion extends along a lateral circumference of the power semiconductor device and has an inclination angle relative to a plane parallel to the first side in a range between 80° and 100°, or in a range between 85° and 95°. Exemplarily, the inclination angle is determined by a shape of a singulation tool.

In this exemplary embodiment the mold compound pattern portion protects the first side of each semiconductor die up to a circumferential edge of the semiconductor die, exemplarily in the whole area between the outer circumferential edge and the active region. Accordingly, the edge termination region is protected against particles, humidity and hazardous gases most efficiently.

It is also an object of the invention to provide a method for manufacturing a molded power package with improved long-term stability and reliability. This object of the invention is attained by a method according to claim 14. According to this method any termination region in the at least one power semiconductor device is protected against particles, humidity and hazardous gases by the mold compound pattern portion already before encapsulating the at least one power semiconductor device by molding. In an exemplary embodiment, a first molding material of the mold compound pattern portion is different from a second molding material, which is used in the step of encapsulating the at least one power semiconductor device by molding. In such exemplary embodiment the first and the second molding materials may be chosen to provide an improved overall protection against impurities and mechanical damage. Exemplarily, the dielectric strength of the first molding material may be higher than that of the second molding material. In the method for manufacturing a molded power package the at least one power semiconductor device may be encapsulated together with other elements such as a substrate and/or a lead frame. Before the step of encapsulating an electrical connection may be provided between a lead frame and the at least one power semiconductor device. The at least one power semiconductor device may be fully encapsulated or may be only partially encapsulated such that a molded package formed in the step of encapsulating the least one power semiconductor device has an opening for contacting the at least one power semiconductor device from outside through this opening.

In any exemplary embodiment, the mold compound pattern and the mold compound pattern portion may comprise a mold compound material (also known as a molding compound material) comprising a thermosetting resin such as a phenol resin or an epoxy resin. A mold compound material comprising epoxy resin and a curing agent is known as an epoxy molding compound (EMC) material. In addition, the mold compound material may comprise one or more of a filler, a flame retardant, an adhesion promoter, a parting agent (allowing release from the mold wall after molding), an ion trapping agent, pigments like carbon black and other additives. The epoxy resin comprised in the mold compound material is for example epoxy cresol novolak resin cured with a phenolic curing agent such as phenolic novolak. A filler comprised in the mold compound material may increase the mechanical stability, may increase the dielectric strength and/or may reduce the coefficient of thermal expansion of the mold compound material. The mechanical properties of the mold compound material are determined to a large extent by the filler content in the mold compound material. The filler content in the mold compound material may for example be in a range between 75 wt% (percent by weight) and 95 wt% to improve the mechanical strength of the mold compound material compared to other known mold compound materials. Using silica (SiO2) or a ceramic like aluminium nitride (AlN), sapphire (Al₂O₃) or boron nitride (BN) as a filler material can increase the dielectric strength of the mold compound material. Exemplarily, spherical silica may be comprised in the mold compound material as a filler. The mold compound material may comprise a different resin than epoxy cresol novolak and/or comprise a different curing agent than a phenolic curing agent known to the person skilled in the art. For example, the mold compound material may comprise another thermosetting resin or thermoset polymer or a biphenyl epoxy resin. The adhesion promoter may be an inorganic or an organic material like epoxy silanes or amino silanes. The mold compound material may comprise an ion trapping agent such as e.g. bismuth to more efficiently protect the semiconductor wafer. Improvement of humidity absorption can be achieved by oxides (e.g. Al-, Fe-, Mg-oxides). Catalysts such as amines or imidazole may be comprised in the mold compound material.

Throughout the specification, a lateral direction may be also defined as a direction parallel to the second (main) side instead of being defined as a direction parallel to the first (main) side. In case of an uneven first side of the semiconductor die (or uneven first main side of the semiconductor wafer), a lateral direction parallel to the first (main) side is to be understood as a direction parallel to a reference plane for which the arithmetic mean value of a distance between the first (main) side and the reference plane is minimal (compared to all other planes), wherein the arithmetic mean value is calculated from the distance values of all points on the first (main) side. The same shall apply in case of an uneven second side of the semiconductor die of uneven second main side of a semiconductor wafer.

Throughout the specification, each active region in a semiconductor die (or semiconductor wafer) is to be understood as a predetermined region of the semiconductor die (or semiconductor wafer), which predetermined region is laterally surrounded (i.e. encircled) by a corresponding one of the termination regions such that in an orthogonal projection onto a plane parallel to the second (main) side, the termination region is directly adjacent to the active region without any overlap of the active region and the corresponding termination region and no other region being interposed between the active region and the corresponding termination region. Each edge termination region in the semiconductor die (or semiconductor wafer) is a region of the semiconductor die (or semiconductor wafer) in which a structure for lowering an electric field (during operation of a power semiconductor device using the active region surrounded by the edge termination region) is provided. Each edge termination region may exemplarily comprise the structure of any planar edge termination known by a person skilled in the art, such as a structure with floating potential field or guard rings, a junction termination extension (JTE) structure, a variation of lateral doping (VLD) structure or others.

### BRIEF DESCRIPTION OF THE DRAWINGS

Detailed embodiments of the invention will be explained below with reference to the accompanying figures, in which:
- FIGs. 1A and 1B: show a semiconductor wafer provided in a method for manufacturing a plurality of power semiconductor devices according to an exemplary embodiment;
- FIG. 2: illustrates a step of forming a passivation layer in the method for manufacturing a plurality of power semiconductor devices according to the exemplary embodiment;
- FIG. 3: illustrates a step of forming electrode layers on a first main side and on a second main side, respectively, in the method for manufacturing a plurality of power semiconductor devices according to the exemplary embodiment;
- FIG. 4: illustrates the processed semiconductor wafer of FIG. 3 being arranged in a mold for forming a mold compound pattern on the first main side in the method for manufacturing a plurality of power semiconductor devices according to the exemplary embodiment;
- FIG. 5: illustrates a method step of forming the mold compound pattern in the method for manufacturing a plurality of power semiconductor devices according to the exemplary embodiment;
- FIGs. 6A and 6B: show the processed semiconductor wafer after the step of forming the mold compound pattern on the first main side in the method for manufacturing a plurality of power semiconductor devices according to the exemplary embodiment;
- FIGs. 7A and 7B: show one of the plurality of power semiconductor devices formed by separating the processed semiconductor wafer of FIG. 6A into the plurality of power semiconductor devices;
- FIG. 7C: shows an enlarged partial view of section S in FIG. 7B illustrating further details of the power semiconductor device of FIG. 7B;
- FIG. 8: shows a circumferential edge of a power semiconductor device according to a modified embodiment;
- FIG. 9: shows a circumferential edge of a power semiconductor device according to another modified embodiment;
- FIG. 10: shows the processed semiconductor wafer after the step of forming the mold compound pattern on the first main side in the method for manufacturing a plurality of power semiconductor devices according to another modified embodiment;
- FIG. 11: shows one of the plurality of power semiconductor devices formed by separating the processed semiconductor wafer of FIG. 10 into a plurality of power semiconductor devices;
- FIG. 12: illustrates an exemplary embodiment of a power module comprising the power semiconductor device of FIGs. 7A and 7B;
- FIG. 13: illustrates another exemplary embodiment of a power module comprising the power semiconductor device of FIGs. 7A and 7B;
- FIG. 14: illustrates an exemplary embodiment of a molded power package comprising the power semiconductor device of FIGs. 7A and 7B;
- FIGs. 15A and 15B: illustrate another exemplary embodiment for manufacturing a plurality of power semiconductor devices;
- FIGs. 16A and 16B: show one of the plurality of power semiconductor devices formed by separating the processed semiconductor wafer of FIG. 15A into a plurality of power semiconductor devices; and
- FIGs. 17A and 17B: show a power semiconductor device according to another modified embodiment.

The reference signs used in figures and their meanings are summarized in the list of reference signs. Generally, similar elements have the same reference signs throughout the specification. The described embodiments are meant as an example and shall not limit the scope of the invention.

### DETAILLED DESCRIPTION OF EXEMPLARY EMBODIMENTS

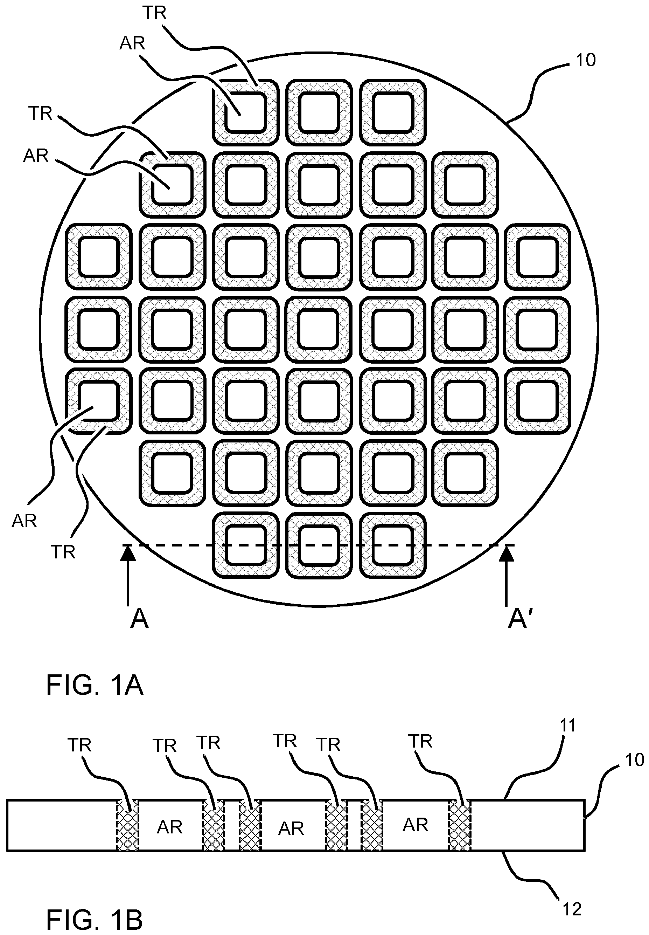

In the following a method for manufacturing a plurality of power semiconductor devices 60 according to an exemplary embodiment will be described with reference to FIGs. 1 to 7C.

In a first method step a semiconductor wafer 10 having a first main side 11 and a second main side 12 opposite to the first main side 11 is provided. The semiconductor wafer 10 may comprise any semiconductor material suitable for manufacturing a power semiconductor device. For example, the semiconductor wafer 10 may comprise a group-IV semiconductor such as silicon (Si), a wide bandgap semiconductor, exemplarily a group-IV compound semiconductor such as silicon carbide (SiC) or a group III-V compound semiconductor, for example a group-III-nitride such as gallium nitride (GaN) or aluminium gallium nitride (AlGaN) or others. FIG. 1A shows the semiconductor wafer 10 in a top view (viewed in a direction perpendicular to the first main side 11) and FIG. 1B shows the semiconductor wafer 10 in a cross section along a line A-A' in FIG. 1A perpendicular to the first main side 11. The semiconductor wafer 10 comprises a plurality of active regions AR, wherein each active region AR is laterally surrounded by an edge termination region TR. Therein, the term laterally refers to a lateral direction parallel to the first main side 11 (or parallel to the second main side 12). In each active region AR a power semiconductor device structure is implemented. The power semiconductor device structure may be the structure of an insulated gate bipolar transistor (IGBT), a power metal-oxide-semiconductor field-effect transistor (MOSFET), a power metal-insulator-semiconductor field-effect transistor (MISFET), a power diode, a junction barrier Schottky (JBS) diode, a thyristor device or of any other kind of power semiconductor device. Therein, the power semiconductor device structure may comprise all elements of a power semiconductor device, which are implemented as semiconductor regions. The edge termination region TR may comprise the structure of any planar edge termination known by a person skilled in the art, such as a structure with floating potential field or guard rings, a junction termination extension (JTE) structure, a variation of lateral doping (VLD) structure or others.

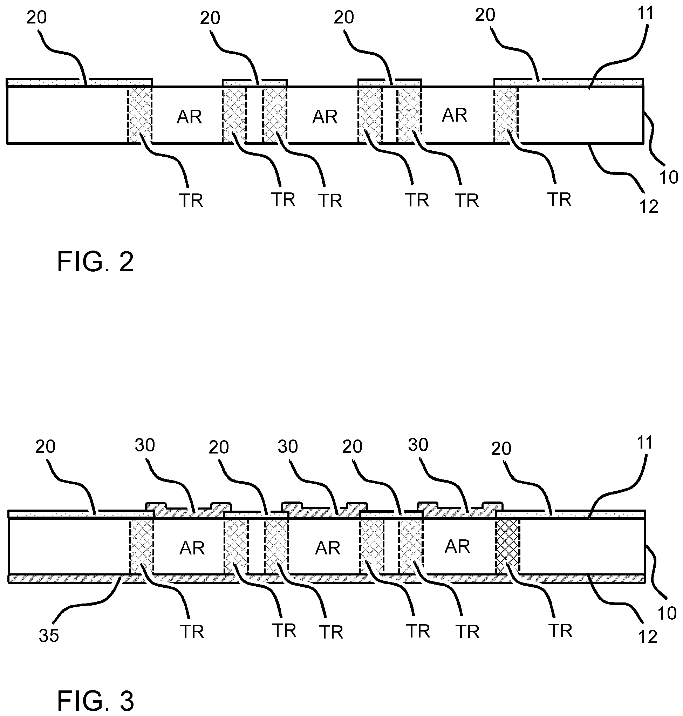

In an optional further method step illustrated in FIG. 2 a passivation layer 20 is formed on the first main side 11. Therein, FIG. 2 shows the processed semiconductor wafer 10 in cross-section corresponding to the cross-section shown in FIG. 1B. The passivation layer 20 may be formed on the first main side 11 at least in areas of the edge termination region TR. Exemplarily, the passivation layer 20 may be formed at least in all areas of the first main side 11 except areas of the active regions AR as shown in FIG. 3. Method steps for forming the passivation layer 20 and suitable materials of the passivation layer 20 are well known to the person skilled in the art and are, therefore, not discussed in further detail herein.

In a method step illustrated in FIG. 3 an electrode layer 30 is formed on the first main side 11 in areas of the active regions AR (when viewed from a direction perpendicular to the first main side 11). As shown in FIG. 3 the electrode layer 30 may overlap the passivation layer 20 in areas of the edge termination region TR. The electrode layer 30 is formed by method steps generally known by the person skilled in the art and may for example comprise a first step of forming a continuous layer which is subsequently patterned by selective etching using a mask layer (not shown in the figures). The electrode layer 30 may comprise a metal material or any other suitable electrically conductive electrode material. A contact between the electrode layer 30 and the semiconductor wafer 10 may be an ohmic contact or a Schottky contact or a combination thereof. A backside electrode layer 35 is formed on the second main side 12 and may, for example, be formed on the whole second main side 12 as a continuous layer.

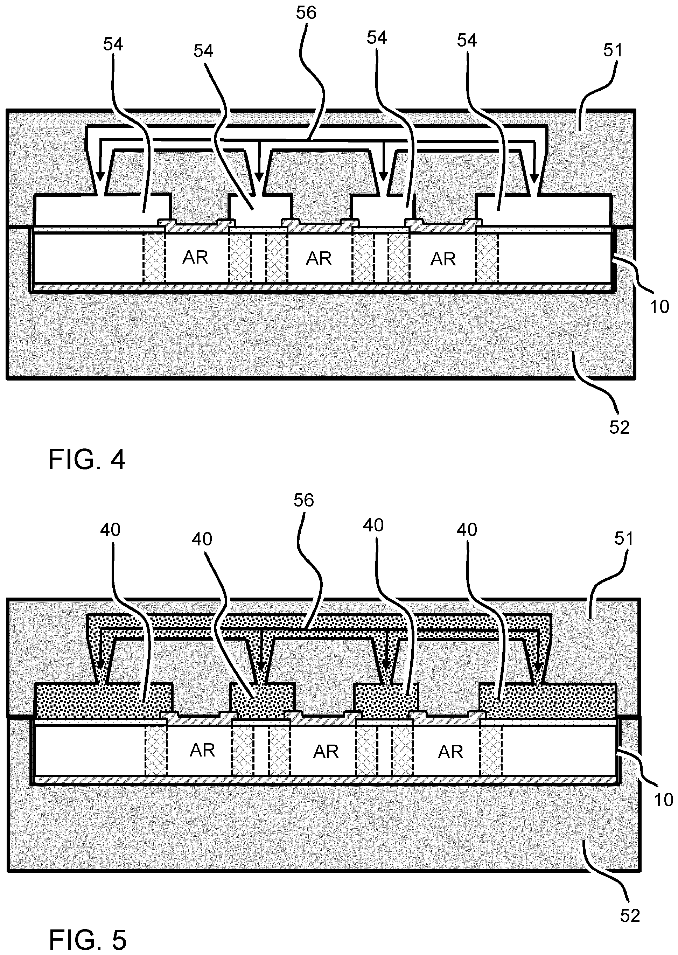

In a next method step the processed semiconductor wafer as shown in FIG. 3 is placed in a mold comprising an upper mold 51 and a lower mold 52 as shown in FIG. 4. The upper mold 51 has recesses which define together with (a top surface of) the processed semiconductor wafer 10 cavities 54 which are to be filled by a mold compound material. The mold compound material is injected into the cavities 54 through a channel system 56 as shown in FIG. 5 to form a mold compound pattern 40 on the first main side 11 in areas of the edge termination region TR in an orthogonal projection onto a plane parallel to the first main side 11. The lower mold 52 may comprise a recess into which the processed semiconductor wafer 10 is inserted to hold the processed semiconductor wafer 10 in place. The mold compound pattern 40 may be formed by any suitable molding method such as compression molding or transfer molding. Suitable molding methods such as compression molding and transfer molding as well as details thereof are known to the person skilled in the art and are, therefore, not described in further detail herein.

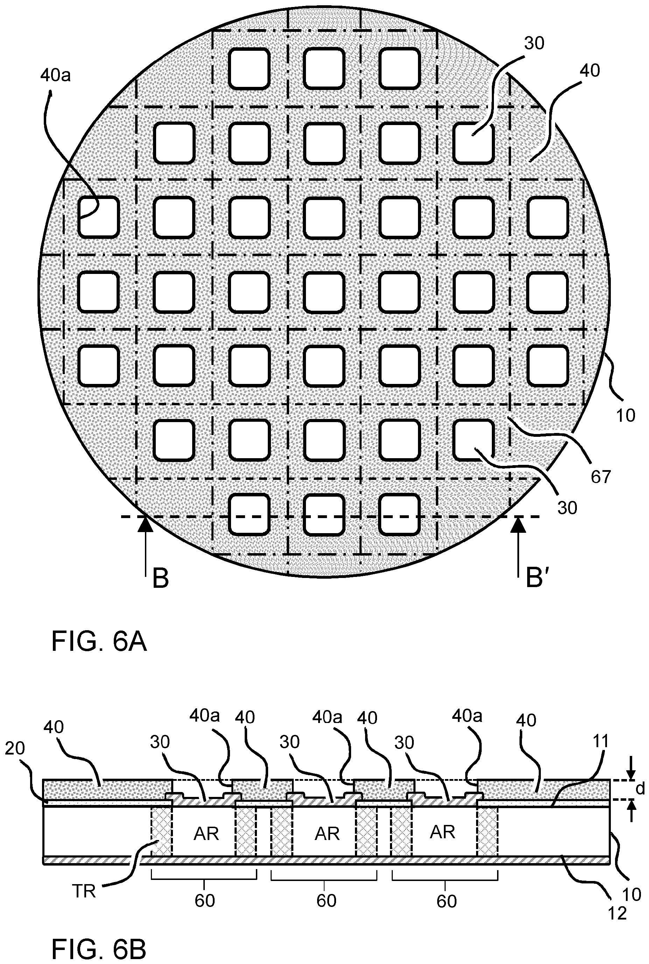

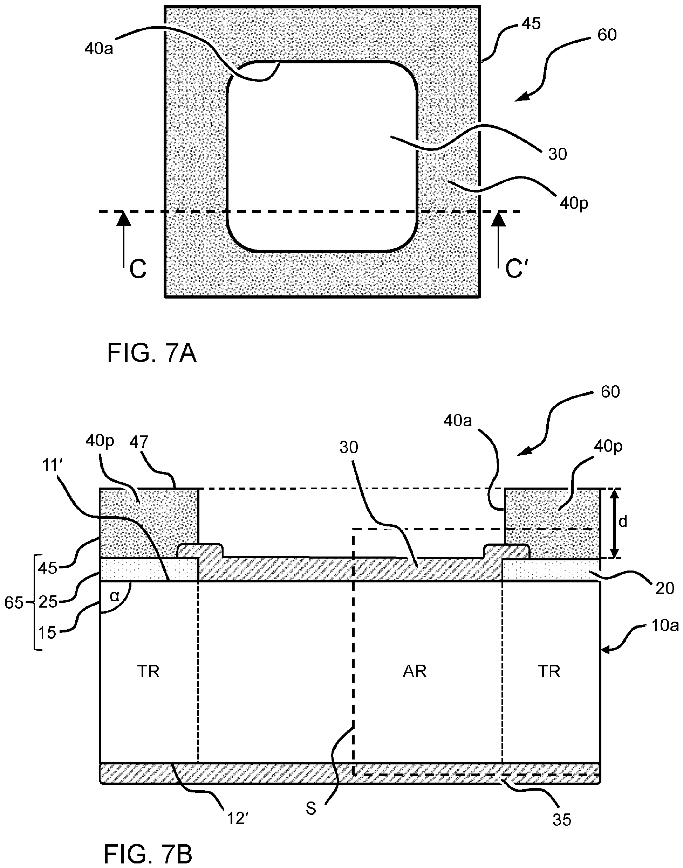

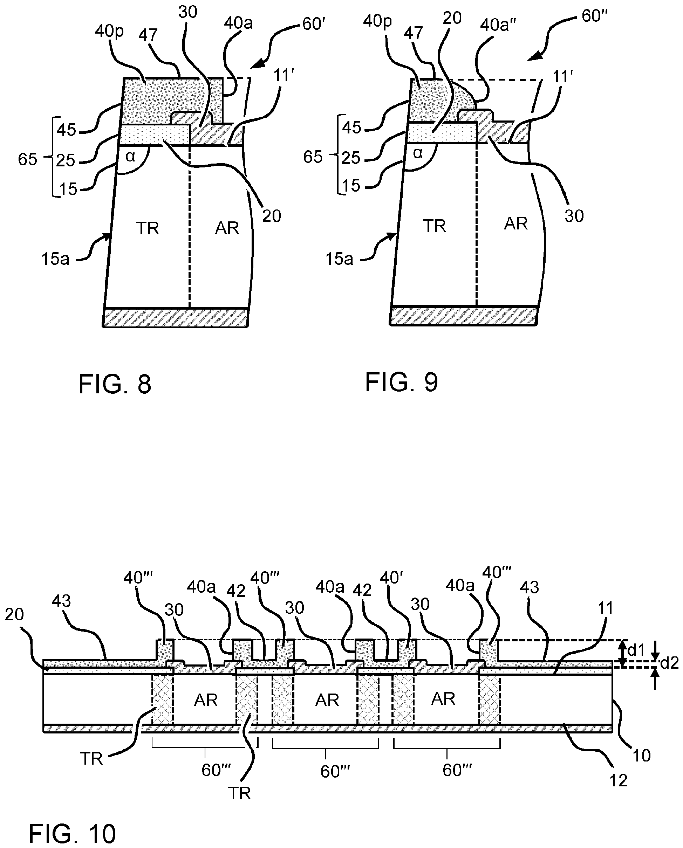

The processed semiconductor wafer 10 after removal from the mold (comprising the upper mold 51 and the lower mold 52) is shown in FIG. 6A and 6B. Therein, FIG. 6A shows a top view of the processed semiconductor wafer 10, and FIG. 6B shows the processed semiconductor wafer 10 in cross section along a line B-B' in FIG. 6A. The mold compound pattern 40 in the embodiment shown in FIG. 6A is a continuous layer comprising a plurality of openings 40a (in the figures, a line connected to reference sign 40a is indicating to an edge of the openings, respectively), wherein each one of the plurality of the openings 40a exposes a portion of the electrode layer 30 on each active region AR. In the exemplary embodiment shown in FIG. 6A any other portion of the semiconductor wafer 10 than the active regions AR is covered by the mold compound pattern 40 on the first main side 11 in an orthogonal projection onto a plane parallel to the first main side 11. The mold compound pattern 40 may overlap also areas of the active region AR as in a power semiconductor device 60' according to a modified embodiment which is shown in FIG. 8 in a partial cross-section corresponding to the cross-sectional view of FIG. 7B. That means that the area exposed by the openings 40a may be smaller than the areas of the active regions AR in an orthogonal projection onto a plane parallel to the first main side 11, respectively. While the thickness of the mold compound pattern 40 is not limited to any specific thickness, a thickness d of the mold compound pattern may be above 100 µm, and the thickness may be up to several millimeter, for example.

The mold compound pattern 40 may comprise a mold compound material (also known as a molding compound material) comprising a thermosetting resin such as a phenol resin or an epoxy resin. A mold compound material comprising epoxy resin and a curing agent is known as an epoxy molding compound (EMC) material. In addition, the mold compound material may comprise one or more of a filler, a flame retardant, an adhesion promoter, a parting agent (allowing release from the mold wall after molding), an ion trapping agent, pigments like carbon black and other additives. The epoxy resin comprised in the mold compound material is for example epoxy cresol novolak resin cured with a phenolic curing agent such as phenolic novolak. A filler comprised in the mold compound material may increase the mechanical stability, may increase the dielectric strength and/or may reduce the coefficient of thermal expansion of the mold compound material. The mechanical properties of the mold compound material are determined to a large extent by the filler content in the mold compound material. The filler content in the mold compound material may be for example in a range between 75 wt% (percent by weight) and 95 wt% to improve the mechanical strength of the mold compound material compared to other known mold compound materials. Using silica (SiO₂) or a ceramic like aluminium nitride (AlN), sapphire (Al₂O₃) or boron nitride (BN) as a filler material can increase the dielectric strength of the mold compound material. Exemplarily, spherical silica may be comprised in the mold compound material as a filler. The mold compound material may comprise a different resin than epoxy cresol novolak and/or comprise a different curing agent than a phenolic curing agent known to the person skilled in the art. For example, the mold compound material may comprise another thermosetting resin or thermoset polymer or a biphenyl epoxy resin. The adhesion promoter may be an inorganic or an organic material like epoxy silanes or amino silanes. The mold compound material may comprise an ion trapping agent such as e.g. bismuth to more efficiently protect the semiconductor wafer. Improvement of humidity absorption can be achieved by oxides (e.g. Al-, Fe-, Mg-oxides) comprised in the mold compound material. In addition catalysts such as amines or imidazole may be comprised in the mold compound material.

In the top view of FIG. 6A a grid of dashed lines 67 is shown. Along these dashed lines 67 the processed semiconductor wafer 10 and the compound mold pattern 40 formed on the first main side 11 are separated into individual power semiconductor devices 60 by dicing such as by sawing or by laser dicing. In the description of other embodiments below such power semiconductor device 60 comprising only one single active region AR laterally surrounded by only one single edge termination region TR is also referred to as a first-type power semiconductor device 60. The areas laterally between neighboring termination regions TR may be referred to as dicing streets. One of the plurality of power semiconductor devices 60 is shown in FIG. 7A in a top view and in FIG. 7B in a vertical cross section along a line C-C' in FIG. 7A. Each one of the plural power semiconductor devices 60 comprises a semiconductor die 10a and a mold compound pattern portion 40p, wherein the semiconductor die 10a is a portion of the semiconductor wafer 10 and wherein the mold compound pattern portion 40p is a portion of the mold compound pattern 40. The semiconductor die 10a has a first side 11' corresponding to the first main side 11 and a second side 12' opposite the first side 11', which second side 12' corresponds to the second main side 12. The top view in FIG. 7A is viewed in a direction perpendicular to the first side 11' and a drawing plane of the vertical cross section of FIG. 7B is perpendicular to the first side 11'. A circumferential lateral surface portion 45 of the mold compound pattern portion 40p is vertically aligned with a circumferential lateral surface portion 15 of the semiconductor die 10a and with a circumferential lateral surface portion 25 of the passivation layer 20 such that the circumferential lateral surface portion 45 of the mold compound pattern portion 40p, the circumferential lateral surface portion 15 of the semiconductor die 10a and the circumferential lateral surface portion 25 of the passivation layer 20 form a continuous lateral surface portion 65 of the power semiconductor device 60 which has a local inclination angle α relative to a plane parallel to the first side 11' (or the second side 12') in a range between 80° and 100° (exemplarily in a range between 85° and 95°) at all points on the continuous lateral surface portion 65 of the power semiconductor device 60. Therein, an inclination angle α is measured on a macroscopic scale neglecting any surface roughness of the continuous lateral surface portion 65. The continuous lateral surface portion 65 may be a surface portion free of steps. The feature regarding the local inclination angle α of the continuous lateral surface portion 65 does not exclude the possibility that another surface portion of the mold compound pattern portion 40p which connects the circumferential lateral surface portion 45 of the mold compound pattern portion 40p with a top surface 47 of the mold compound pattern portion 40p has local inclination angles α outside the range of 80° and 100° (or outside the range of 85° to 95°) relative to the first side 11' (or the second side 12'), or that another surface portion of the semiconductor die 10a connecting the circumferential lateral surface portion 15 of the semiconductor die 10a with the second side 12' has local inclination angles α outside the range of 80° and 100° (or outside the range of 85° to 95°) relative to a plane parallel to the first side 11' (or the second side 12'). Therein, each one of the circumferential lateral surface portion 15 of the semiconductor die 10a, the circumferential lateral surface portion 25 of the passivation layer 20, the circumferential lateral surface portion 45 of the mold compound pattern portion 40p and the continuous lateral surface portion 65 of the power semiconductor device 60 extend respectively along a whole lateral circumference of the power semiconductor device 60 so that they are ribbon-like, ring-shaped surface portions. The continuous lateral surface portion 65 of the power semiconductor device 60 is a cut face formed by the dicing process for separating the processed semiconductor wafer 10 and the compound mold pattern 40 into individual power semiconductor devices 60. A lower edge of the circumferential lateral surface portion 45 of the mold compound pattern portion 40p is connected to an upper edge of the circumferential lateral surface portion 15 of the semiconductor die 10a by the circumferential lateral surface portion 25 of the passivation layer 20. Therein, the lower edge of the circumferential lateral surface portion 45 of the mold compound pattern portion 40p is an edge of the circumferential lateral surface portion 45 of the mold compound pattern portion 40p towards the first side 11', and the upper edge of the circumferential lateral surface portion 15 of the semiconductor die 10a is a ring-shaped line where the circumferential lateral surface portion 15 of the semiconductor die 10a is connected to the first side 11'. Due to the inclination angle α of the circumferential lateral surface portions 15, 25 and 45 being in a range from 80° to 100° (or 85° to 95°) relative to a plane parallel to the first side 11', in an orthogonal projection onto a plane parallel to the first side 11' a (lateral) distance between the lower edge and the upper edge is less than 2 µm (exemplarily less than 1 µm or exemplarily less than 0.5 µm) along the whole lateral circumference of the semiconductor device 60. At least within such limits of a (lateral) distance between the lower edge of the circumferential lateral surface portion 45 of the mold compound pattern portion 40p and the upper edge of the circumferential lateral surface portion 15 of the semiconductor die 10a, the circumferential lateral surface portion 45 of the mold compound pattern portion 40p is understood as being aligned with a circumferential lateral surface portion 15 of the semiconductor die 10a.

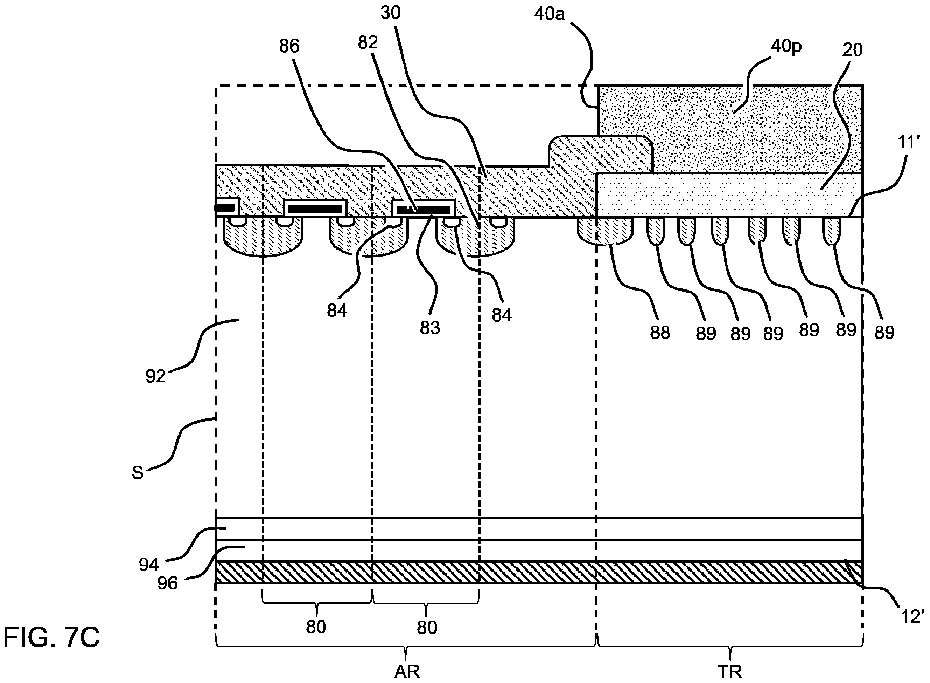

FIG. 7B shows an exemplary embodiment in which the continuous lateral surface portion 65 has an inclination angle α of 90° relative to a plane parallel to the first side 11'. In the cross-section shown in FIG. 7B the continuous lateral surface portion 65 is shown in cross-section as a straight line. That means that there is no variation of the inclination angle α within the continuous lateral surface portion 65. In FIG. 7B it is indicated a section S which is shown in FIG. 7C as an enlarged partial view in more detail. In the power semiconductor device 60' according to the modified embodiment shown in FIG. 8 the inclination angle α is not exactly 90° but above 90°.

In the exemplary embodiment shown in FIG. 7C the power semiconductor device 60 is an IGBT having plural IGBT cells 80 which have substantially a same structure. As shown in FIG. 7C each cell 80 comprises between the first side 11' and the second side 12' the following layers in this order: an n-type emitter layer region 84, a p-type base layer region 82, an n-type drift layer 92, an n-type buffer layer 94, which has a higher doping-level than the drift layer 92, and a p-type collector layer 96. Both, the base layer region 82 and the emitter layer region 84 are arranged adjacent to the first side 11'. The p-type base layer regions 82 are separated from each other in a lateral direction parallel to the first side 11' by portions of the drift layer 92. In a vertical direction perpendicular to the first side 11' the p-type base layer regions 82 are separated from the buffer layer 94 by the drift layer 92. The buffer layer 94 is vertically (i.e. in a direction perpendicular to the first side 11') interposed between the drift layer 92 and the p-type collector layer 96. The drift layer 92, the buffer layer 94 and the p-type collector layer 96 may respectively extend in a lateral direction throughout the whole semiconductor die 10a. On the first side 11' there is formed a gate electrode 86 separated from the semiconductor die 10a and from the electrode layer 30 by an insulation layer 83, a portion of which forms the gate insulation layer for a field effect structure of the IGBT. The IGBT device structure is well known to the person skilled in the art. Accordingly, it is refrained from discussing the IGBT device structure in further detail herein. As indicated above, the power semiconductor device 60 may have another power semiconductor device structure and an IGBT is only one of plural exemplary embodiments for the power semiconductor device structure that may be implemented in the power semiconductor device 60.

In the edge termination region TR of the exemplary embodiment shown in FIG. 7C there is formed a planar edge termination structure comprising a plurality of floating field rings 89 laterally surrounding the active region AR. Each one of the floating field rings 89 extends in a vertical direction perpendicular to the first side 11' from the first side 11' into the semiconductor die 10a towards the second side 12'. In addition, a p-type ring 88 connected to the electrode layer 30 is arranged at the border between the active region AR and the edge termination region TR. However, an edge termination structure formed in the edge termination region TR is not limited to any specific edge termination structure and may be any other edger termination structure, and may be exemplarily any other planar edge termination structure.

FIG. 8 shows a circumferential edge of a power semiconductor device 60' according to the modified embodiment in a vertical cross-section along a line corresponding to line C-C' in FIG. 7A. This power semiconductor device 60' according to the modified embodiment differs from that shown in FIG. 7B in that the continuous lateral surface portion 65 comprising the circumferential lateral surface portion 45 of the mold compound pattern portion 40p and the circumferential lateral surface portion 15 of the semiconductor die 10a has an inclination angle α above 90° relative to a plane parallel to the first side 11'. In addition it differs from the power semiconductor device 60 of FIG. 7B in that the mold compound pattern portion 40p extends onto and overlaps the active region AR, i.e. the opening 40a is in an orthogonal projection onto a plane parallel to the first side 11' smaller than an area of the active region AR. Otherwise the power semiconductor device 60' of the modified embodiment illustrated in FIG. 8 and also a method for manufacturing the same has the same features as explained above for the exemplary embodiment with reference to FIGs. 1 to 7C.

FIG. 9 shows a circumferential edge of a power semiconductor devices 60" according to another modified embodiment in a vertical cross-section along a line corresponding to line C-C' in FIG. 7A. This power semiconductor device 60" according to the modified embodiment differs from that shown in FIG. 7B only in that the continuous lateral surface portion 65 comprising the circumferential lateral surface portion 45 of the mold compound pattern portion 40p and the circumferential lateral surface portion 15 of the semiconductor die 10a has an inclination angle α above 90° relative to a plane parallel to the first side 11' as in the modified embodiment illustrated in FIG. 8 and in that an (inner) edge of the compound pattern portion 40p defining the openings 40a" is rounded. Otherwise the power semiconductor device 60" of the modified embodiment illustrated in FIG. 9 and a method for manufacturing the same has the same features as explained above for the exemplary embodiment with reference to FIGs. 1 to 7C.

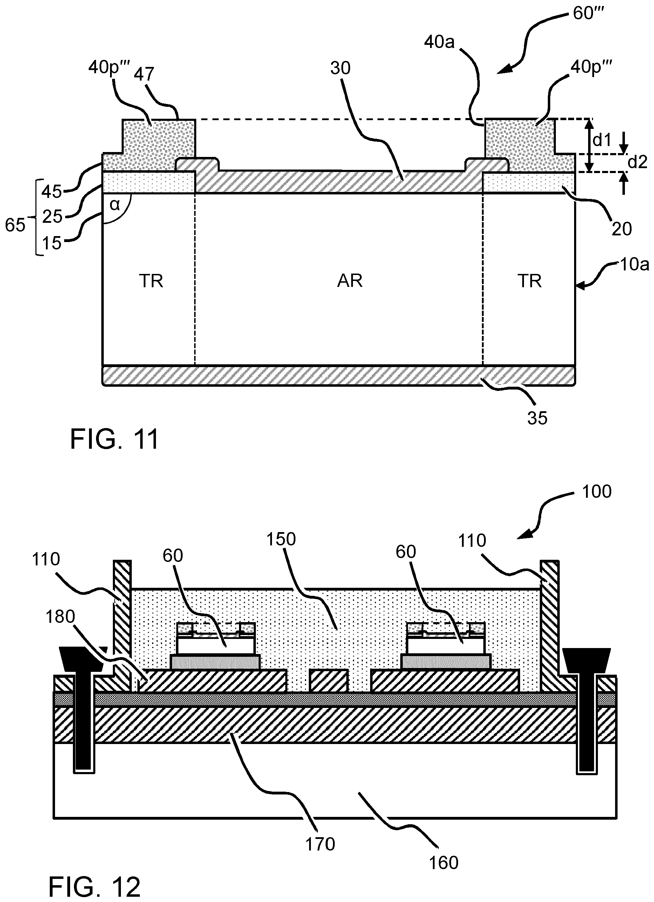

FIGs. 10 and 11 illustrate another modification of the exemplary embodiment discussed above with reference FIGs. 1 to 7C. FIG. 10 shows the processed semiconductor wafer 10 after the step of forming a mold compound pattern 40"' on the first main side 11 in a modified method for manufacturing a plurality of power semiconductor devices 60'" in a vertical cross-section perpendicular to the first main side 11 along a line corresponding to line B-B' in Fig. 6A. A mold compound pattern 40'" in this modification of the exemplary embodiment differs from the mold compound pattern 40 in the embodiment of FIGs. 1 to 7C in that it does not have a constant thickness d but has a larger first thickness d1 in areas surrounding the active region AR and has a smaller second thickness d2<d1 in areas between neighbouring termination regions TR and in an area extending along the circumferential edge of the semiconductor wafer 10. Accordingly, the mold compound pattern 40"' has a first recessed portion 43 extending along the circumferential edge of the semiconductor wafer 10 and has second recessed portions 42 extending between neighbouring active regions AR in an orthogonal projection onto a plane parallel to the first main side 11. One of the plurality of power semiconductor devices 60"' obtained by separating the processed wafer 10 shown in FIG. 10 into plural power semiconductor devices 60'" is shown in FIG. 11 in a vertical cross-section along a line corresponding to line C-C' in FIG. 7A. The mold compound pattern portion 40p'" has a first portion (which is an inner portion adjacent to the active region AR and which defines and forms and edge of the opening 40a) which has the first thickness d1 and an outer second portion of the mold compound pattern portion 40p extending along a circumferential edge of the power semiconductor device 60"', the second portion having the second thickness d2<d1.

In the following, an exemplary embodiment of a power module 100 and a method for manufacturing the power module 100 is described with reference to FIG. 12.

The method for manufacturing the power module 100 comprises arranging at least one of the power semiconductor devices 60 manufactured by a method described above with reference to FIGs. 1 to 7C in the housing frame 110 and thereafter filling a cavity inside of the housing frame 110 with a dielectric gel 150 as shown in FIG. 12. Before arranging the power semiconductor device 60 in the housing frame 110, it may be arranged on a substrate. The housing frame 110 may be connected to a cooler 160 and comprise further elements such as a base plate 170 on which a copper layer 180 is attached via soldering, wherein the at least one power semiconductor device 60 is soldered onto the copper layer 180. FIG. 12 shows the final power module 100 manufactured by the before described method in cross section. Further details of the power module 100 which are in general known to the person skilled in the art are not described here in further detail.

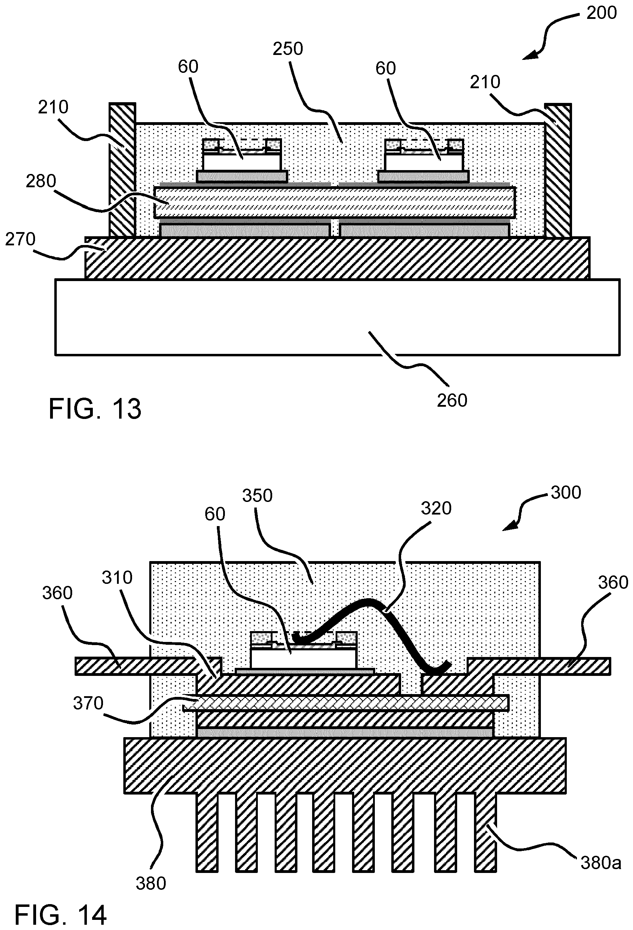

In FIG. 13 there is shown another power module 200 according to another exemplary embodiment in cross section. The power module 200 comprises a housing frame 210 attached to a cooler 260 via a base plate 270 to which is soldered, for example, a substrate 280 such as a direct bonded copper (DBC) substrate, onto which the at least one power semiconductor device 60 is attached by, for example, soldering. The method for manufacturing the power module 200 differs from the method for manufacturing the power module 100 described above in that a cavity in the housing frame 210 is not filled with dielectric gel 150 but with an epoxy material 250.

In the following a method for manufacturing a molded power package 300 according to an exemplary embodiment is described with reference to FIG. 14. The method comprises a method for manufacturing plural power semiconductor devices 60 as described above, and attaching at least one of the plural power semiconductor devices 60 onto a lead frame 310, wherein the lead frame is attached via a substrate layer 370 to a base plate 380 comprising cooling fins 380a. In a next method step an electrical connection is provided between the at least one power semiconductor device 60 and the lead frame 310. In the embodiment shown in FIG. 14 the electrical connection between the at least one power semiconductor device 60 and the lead frame 310 comprises a bonding wire 320 bonded onto the power semiconductor device 60 and onto the lead frame 310, respectively. The resulting structure with the at least one power semiconductor device 60 electrically connected to the lead frame 310 is then packaged by encapsulating the at least one power semiconductor device 60 together with the lead frame 310 by molding in a molded package 350. Therein the compound pattern portion 40p of the power semiconductor device 60 comprises a first molding material and the molded package 350 comprises a second molding material, wherein the first molding material may be different from the second molding material. Exemplarily, a dielectric strength of the first molding material may be higher than that of the second molding material.

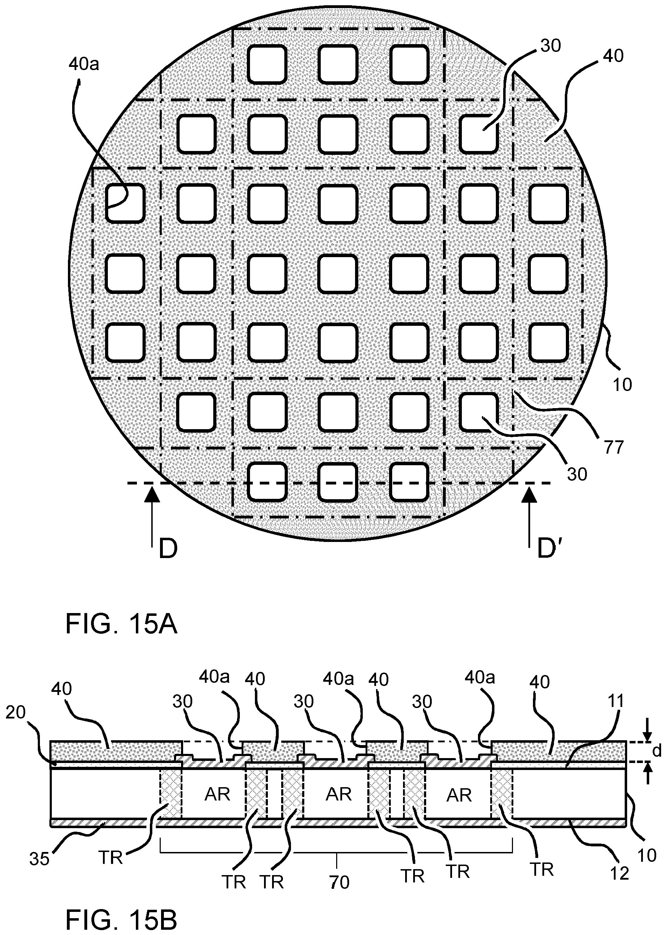

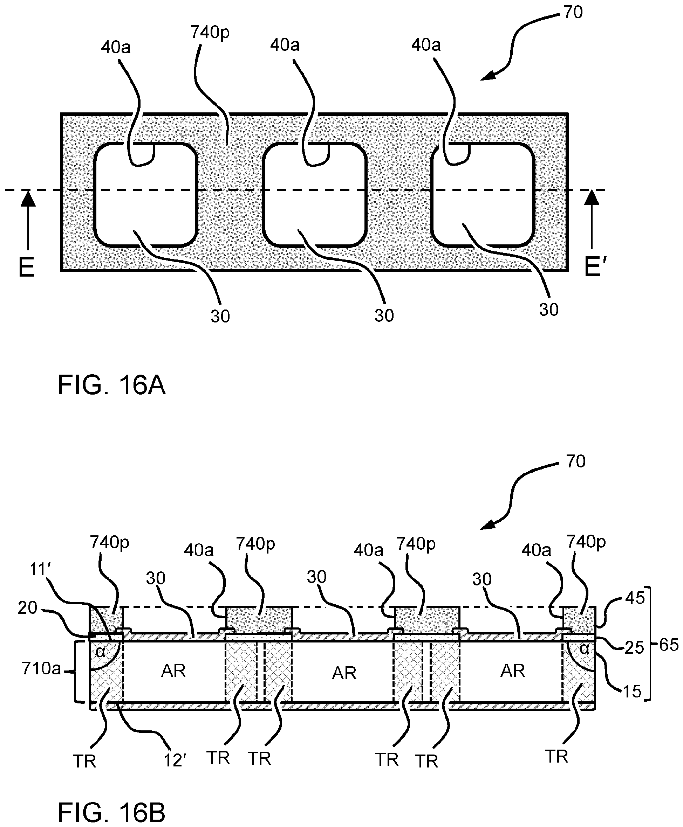

In the following, another embodiment for manufacturing a plurality of power semiconductor devices is described with reference to figures 15A to 16B. Due to the many similarities between the method for manufacturing a plurality of power semiconductor devices 60 as described above with reference to figures 1 to 7C and the present embodiment, only differences to the above described method are discussed in the following. Identical reference signs shall refer to elements that have the same features and characteristics as described above. FIG. 15A shows a processed semiconductor wafer which is identical to the processed semiconductor wafer shown in FIG. 6A. In FIG. 15B a cross section of the processed semiconductor wafer shown in FIG. 15A along a line D-D' is shown. As can be seen from comparing FIG. 15B with FIG. 6B the structure of the semiconductor wafer 10 in cross section is identical. However, the method for manufacturing a plurality of power semiconductor devices described with reference to figures 15A to 16B differs from the method described above with reference to FIGs. 1 to 7C in that the processed semiconductor wafer 10 shown in FIG. 15A is separated along lines 77 into plural power semiconductor devices comprising a second type power semiconductor device 70 which comprises plural active regions AR, wherein each one of the plural active regions AR is laterally surrounded by an edge termination region TR. Each active region AR in the second-type power semiconductor device 70 is laterally separated at least by the edge termination region TR surrounding this active region AR from all other active regions AR in the same second-type power semiconductor device 70. As can be seen from FIG. 15A the plural power semiconductor devices into which the semiconductor wafer shown in FIG. 16A is separated along lines 77 comprise nine second-type power semiconductor devices 70 (eight second-type power semiconductor devices 70 with respectively three active regions AR and one second-type power semiconductor device 70 with nine active regions AR) and four first-type power semiconductor devices 60 with only a single active region AR. FIG. 16A shows one of the second-type power semiconductor devices 70 in a top view and FIG. 16B shows one of the second-type power semiconductor devices 70 with three active regions AR in a cross section along line E-E'. The views in FIGs. 16A and 16B correspond to the views shown in FIGs. 7A and 7B. As can be seen from FIG. 16B, the second-type power semiconductor device 70 comprises a semiconductor die 710a which is a part of the semiconductor wafer 10 and a mold compound pattern portion 740p which is a part of the mold compound pattern 40. As can be seen from FIG. 16A, the mold compound pattern portion 740p comprises plural openings 40a, wherein each one of the plural openings 40a exposes the electrode layer 30 arranged on the plural active regions AR of the second-type power semiconductor device 70. Similar to the above described embodiment a circumferential lateral surface portion 45 of the mold compound pattern portion 740p is aligned with a circumferential lateral surface portion 15 of the semiconductor die 710a. For further details regarding the continuous lateral surface portion 65 it is referred to the description of power semiconductor devices 60, 60', 60" and 60"' discussed above.

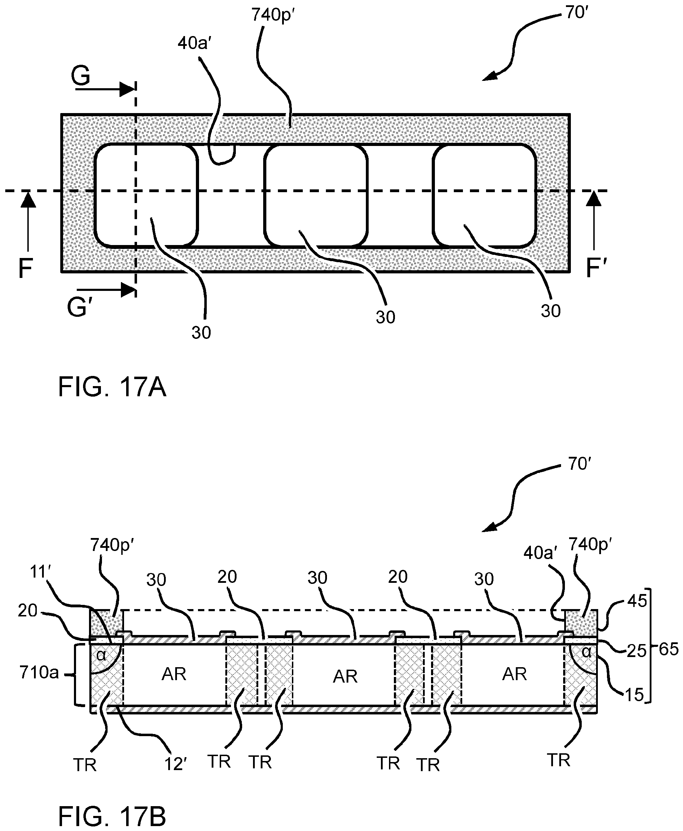

In FIGs. 17A and 17B there is shown a power semiconductor device 70' according to another modified embodiment. FIG. 17A is a view corresponding to the FIG. 16A and shows a top view of the power semiconductor device 70'. FIG. 17B is a view corresponding to FIG. 16B and shows a vertical cross-section of the power semiconductor device 70' along line F-F' in FIG. 17A. A cross-section along line G-G' in FIG. 17A corresponds to the cross-section shown in FIG. 7B. The power semiconductor device 70' shown in FIGs. 17A and 17B differs from the power semiconductor device 70 according to the embodiment shown in FIGs. 16A and 16B only in that there is only one larger opening 40a' in the mold compound pattern portion 740p' which opening 40a' exposes each portion of the electrode layer 30 on all active regions AR, whereas the mold compound pattern portion 740p of the embodiment shown in FIGs. 16A and 16B has plural openings 40a, each opening 40a exposing a portion of the electrode layer 30 on one single active region AR only. The mold compound pattern portion 740p' in the modified embodiment extends only along the circumferential edge of the power semiconductor device 70', whereas (contrary to the embodiment shown in FIGs. 16A and 16B) no mold compound pattern portion 740p' is formed in areas between neighbouring active regions AR (in an orthogonal projection onto a plane parallel to the first side 11' of semiconductor die 710a). Accordingly, only portions of the edge termination regions TR are covered with the mold compound pattern portion 740p' which are exposed to the highest electrical fields during (blocking) operation of the power semiconductor device 70'.

It will be apparent for a person skilled in the art that modifications of the above described embodiments are possible without departing from the scope of the invention as defined by the appended claims. For example, combination of features from different embodiments may be possible which are within the scope of the appended claims.

The above embodiments were explained with specific conductivity types. The conductivity types of the semiconductor layers in the above described embodiments might be switched, so that in a specific embodiment all layers which were described as p-type layers would be n-type layers and all layers which were described as n-type layers would be p-type layers.

The above embodiments were described with the passivation layer 20 between the mold compound pattern 40, 40'" and the semiconductor wafer 10 (or between the mold compound pattern portion 40p, 40p"', 740p, 740p' and the semiconductor die 10a, 710a in the power semiconductor devices 60, 60', 60", 60'", 70 and 70'). However, the mold compound pattern 40, 40'" (mold compound pattern portion 40b, 40p'", 740p, 740p') may be formed directly on the first main side 11 (first side 11') of the semiconductor wafer 10 (semiconductor die 10a, 710a). In this case the lower edge of the circumferential lateral surface portion 45 of the mold compound pattern portion 40p, 40p"', 740p, 740p' is directly connected to the upper edge of the circumferential lateral surface portion 15 of the semiconductor die 10a, 710a.

In all embodiments, the continuous lateral surface portion 65 had a constant inclination angle α in FIGs. 7B, 8, 9, 16B and 17B. However, the inclination angle α may vary and the continuous lateral surface portion 65 may be curved in the vertical cross-sections shown in FIGs. 7B, 8, 9, 16B and 17B.

In the above embodiments an outer circumferential edge of the mold compound pattern 40, 40'" is shown to be aligned with the outer circumferential edge of the semiconductor wafer 10. Accordingly, in the method steps illustrated in FIGs. 4 and 5 the mold compound pattern 40 extends exactly to the outer circumferential edge of the semiconductor wafer. However, such alignment is not necessary and the mold compound pattern 40, 40"' may extend not on a peripheral portion of the semiconductor wafer 10 adjacent to a circumferential edge thereof, which peripheral portion is not used as a portion of the manufactured plural power semiconductor devices 60, 60', 60", 60'", 70 and 70'. In another modification the mold compound pattern 40, 40'" may also extend onto lateral sides of the semiconductor wafer 10.

The above embodiments of the reverse conducting power semiconductor device are illustrated with a circular semiconductor wafer 10. However, the semiconductor wafer may have any other shape such as a rectangular or a polygon shape.

The second-type power semiconductor device shown in FIG. 16A and 16B has three separate active areas AR respectively laterally surrounded by an edge termination region TR. However, the second-type power semiconductor device 70 may also have any other number of active areas AR. Also, while the second conductivity-type power semiconductor device 70 is shown with plural active regions arranged in row along a line from the left to the right in FIGs. 16A and 16B, the plural active regions AR do not have to be arranged in a row along a line but may also be arranged in a matrix, i.e. arranged in two directions (e.g. in a 3x3 matrix in the center of the semiconductor wafer shown in FIG. 15A) or in any other connected shape.

The power module 100 of FIG. 12 was described with at least one first-type power semiconductor device 60 and is shown in FIG. 12 with two first-type power semiconductor devices 60. The power module 100 may comprise any number of first-type power semiconductor devices 60. Also, the power module 100 may comprise any other first-type power semiconductor device 60', 60", 60"' and/or one or more second-type power semiconductor devices 70, 70' instead or in addition to the at least one first-type power semiconductor device 60. Likewise the power module 200 of FIG. 13, which was described with at least one first-type power semiconductor device 60 and shown in FIG. 13 with two first-type power semiconductor devices 60, may comprise any number of first-type power semiconductor devices 60. Also, the power module 200 may comprise any other first-type power semiconductor device 60', 60", 60'" and/or one or more second-type power semiconductor devices 70, 70' instead or in addition to the at least one first-type power semiconductor device 60.

The power module 100 of FIG. 12 was described with dielectric gel 150 and the power module 200 of FIG. 13 was described with epoxy material 250. However, also in the power module 100 of FIG. 12 an epoxy material 250 might be used instead or in addition to the dielectric gel 150, and also in the power module 200 of FIG. 13 a dielectric gel 150 might be used instead or in addition to the epoxy material 250.

It should be noted that the term "comprising" does not exclude other elements or steps and that the indefinite article "a" or "an" does not exclude the plural. Also elements described in association with different embodiments may be combined.

### List of reference signs

- 10: semiconductor wafer
- 10a, 710a: semiconductor die
- 11: first main side
- 11': first side
- 12: second main side
- 12': second side
- 15: circumferential lateral surface portion of the semiconductor die
- 20: passivation layer
- 25,: circumferential lateral surface portion of the passivation layer
- 30: electrode layer
- 35: backside electrode layer
- 40, 40"': mold compound pattern
- 40a, 40a', 40a": (edge of) opening
- 40p, 40p"', 740p, 740p': mold compound pattern portion
- 42: second recessed portion
- 43: first recessed portion
- 45: circumferential lateral surface portion of the mold compound pattern portion
- 47: top surface
- 51: upper mold
- 52: lower mold
- 54: cavity
- 56: channel system
- 60, 60', 60", 60'": (first-type) power semiconductor device
- 65: continuous lateral surface portion
- 70, 70': (second-type) power semiconductor device
- 67, 77: line
- 80: IGBT cell
- 82: p-type base layer region
- 83: insulation layer
- 84: n-type emitter layer region
- 86: gate electrode
- 88: p-type ring
- 89: floating field ring
- 92: drift layer
- 94: buffer layer
- 96: p-type collector layer
- 100,200: power module
- 110, 210: housing frame
- 150: dielectric gel
- 160, 260: cooler
- 170: baseplate
- 180: copper layer
- 250: epoxy material
- 280: substrate
- 300: molded power package
- 310: lead frame
- 320: electrical connection
- 350: molded package
- 360: terminal portion
- 370: substrate layer
- 380: baseplate
- 380a: cooling fin
- α: inclination angle
- d: thickness
- d1: first thickness
- d2: second thickness
- AR: active region
- S: section
- TR: edge termination region

## Claims

1. A power semiconductor device (60; 60'; 60"; 60'"; 70; 70') comprising a semiconductor die (10a; 710a) and a mold compound pattern portion (40p, 40p"', 740p, 740p'), wherein:
the semiconductor die (10a; 710a) has a first side (11') and a second side (12') opposite to the first side (11'),
the semiconductor die (10a; 710a) comprises at least one active region (AR), each one of the at least one active region (AR) being laterally surrounded by an edge termination region (TR), wherein laterally relates to a lateral direction parallel to the first side (11'), and
the mold compound pattern portion (40p; 40p'"; 740p; 740p') being arranged on the first side (11') such that it overlaps the edge termination region (TR) in an orthogonal projection onto a plane parallel to the first side (11'),
**characterized in that** a circumferential lateral surface portion (45) of the mold compound pattern portion (40p; 40p'"; 740p; 740p') is aligned with a circumferential lateral surface portion (15) of the semiconductor die (10a; 710a), wherein the circumferential lateral surface portion (45) of the mold compound pattern portion (40p; 40p'"; 740p; 740p') and the circumferential lateral surface portion (15) of the semiconductor die (10a; 710a) are both at least a part of a continuous lateral surface portion (65) of the power semiconductor device (60; 60'; 60"; 60'"; 70; 70'), wherein the continuous lateral surface portion (65) extends along a lateral circumference of the power semiconductor device (60; 60'; 60"; 60'"; 70; 70') and has an inclination angle (α) relative to a plane parallel to the first side (11') in a range between 80° and 100°, or in a range between 85° and 95°.

2. The power semiconductor device (60; 60'; 60"; 60'") according to claim 1, wherein the semiconductor die (10a) comprises only one single active region (AR) laterally surrounded by a single edge termination region (TR).

3. The power semiconductor device (70; 70') according to claim 1, wherein the semiconductor die (710a) comprises a plurality of active regions (AR), wherein each one of the plurality of active regions (AR) is laterally surrounded and separated from the other ones of the plurality of active regions (AR) by at least one of the edge termination regions (TR).

4. A molded power package (300) comprising the power semiconductor device (60; 60'; 60"; 60'"; 70; 70') according to any one of claims 1 to 3, and a molded package (350), wherein the mold compound pattern portion (40p; 40p'"; 740p; 740p') comprises a first molding material and the molded package (350) comprises a second molding material, the first molding material being different from the second molding material.

5. A power module (100; 200) comprising the power semiconductor device (60; 60'; 60"; 60'"; 70; 70') according to any one of claims 1 to 3, and a housing frame (110; 210), in which the power semiconductor device (60; 60'; 60"; 60'"; 70; 70') is arranged, wherein a cavity inside of the housing frame (110; 210) is filled with a dielectric gel (150) or an epoxy material (250).

6. A method for manufacturing a plurality of the power semiconductor devices (60; 60'; 60"; 60'"; 70; 70') according to any one of the preceding claims, the method comprising:
providing a semiconductor wafer (10) having a first main side (11) and a second main side (12) opposite to the first main side (11), the semiconductor wafer (10) comprising a plurality of active regions (AR) wherein each active region (AR) is laterally surrounded by an edge termination region (TR), wherein laterally relates to a lateral direction parallel to the first main side (11);
forming a mold compound pattern (40; 40'") on a portion of the first main side (11) overlapping in an orthogonal projection onto a plane parallel to the first main side (11) at least a portion of the edge termination regions (TR); and
thereafter separating the semiconductor wafer (10) and the mold compound pattern (40; 40'") along lines (67; 77) extending laterally between neighbouring edge terminations regions (TR) to obtain the plurality of power semiconductor devices (60; 60'; 60"; 60'"; 70; 70').

7. The method for manufacturing a plurality of power semiconductor devices (60; 60'; 60"; 60'"; 70; 70') according to claim 6, wherein an electrode layer (30) is formed on the first main side (11) to cover at least a portion of each active region (AR) before the step of forming the mold compound pattern (40; 40'"), and wherein the mold compound pattern (40; 40'") exposes at least a portion of the electrode layer (30) on each active region (AR).

8. The method for manufacturing a plurality of power semiconductor devices (60; 60'; 60"; 60'"; 70; 70') according to claim 7, wherein the mold compound pattern (40; 40'") is a continuous layer comprising a plurality of openings (40a; 40a'; 40a"), each one of the plurality of openings (40a; 40a'; 40a") exposing the portion of the electrode layer (30) on each active region (AR).

9. The method for manufacturing a plurality of power semiconductor devices (60; 60'; 60"; 60'"; 70; 70') according to any one of claims 6 to 8, comprising a step of forming a passivation layer (20) on the first main side (11) in areas of the edge termination regions (TR) before the step of forming the mold compound pattern (40; 40'").

10. The method for manufacturing a plurality of power semiconductor devices (60; 60'; 60"; 60'"; 70; 70') according to any one of claims 6 to 9, wherein the mold compound pattern (40; 40'") is formed by molding or transfer molding.

11. The method for manufacturing a plurality of power semiconductor devices (60; 60'; 60"; 60'"; 70; 70') according to any one of claims 6 to 10, wherein after the step of separating the semiconductor wafer (10) and the mold compound pattern (40; 40'") into a plurality power semiconductor devices (60; 60'; 60"; 60'"; 70; 70'), each one of the plurality of power semiconductor devices (60; 60'; 60"; 60'"; 70; 70') comprises a semiconductor die (10a; 710a) and a mold compound pattern portion (40p; 40p'"; 740p; 740p'), wherein the semiconductor die (10a; 710a) is a portion of the semiconductor wafer (10) and the mold compound pattern portion (40p; 40p'"; 740p; 740p') is a portion of the mold compound pattern (40; 40'"), wherein a circumferential lateral surface portion (45) of the mold compound pattern portion (40p; 40p"'; 740p; 740p') is aligned with a circumferential lateral surface portion (15) of the semiconductor die (10a; 710a), wherein the circumferential lateral surface portion (45) of the mold compound pattern portion (40p; 40p"'; 740p; 740p') and the circumferential lateral surface portion (15) of the semiconductor die (10a; 710a) are both at least a part of a continuous lateral surface portion of the power semiconductor device (60; 60'; 60"; 60"'; 70; 70'), wherein the continuous lateral surface portion (65) extends along a lateral circumference of the power semiconductor device (60; 60'; 60"; 60'"; 70; 70') and has an inclination angle (α) relative to a plane parallel to the first side (11') in a range between 80° and 100°, or in a range between 85° and 95°.

12. The method for manufacturing a plurality of power semiconductor devices (60; 60'; 60"; 60'"; 70; 70') according to any one of claims 6 to 11, wherein the mold compound pattern (40; 40'") is made of an epoxy mold compound material.

13. The method for manufacturing a plurality of power semiconductor devices (60; 60'; 60"; 60'"; 70; 70') according to any one of claims 6 to 12, wherein at least one of the plurality of power semiconductor devices (60; 60'; 60"; 60'"; 70; 70') is the power semiconductor device according to any one of claims 1 to 3, wherein the semiconductor die (10a; 710a) is a portion of the semiconductor wafer (10) and the mold compound pattern portion (40p; 40p'"; 740p; 740p') is a portion of the mold compound pattern (40; 40'").

14. A method for manufacturing a molded power package (300), the method comprising the method for manufacturing a plurality of power semiconductor devices (60; 60'; 60"; 60'"; 70; 70') according to any one of claims 6 to 13, and encapsulating at least one of the plural power semiconductor devices (60; 60'; 60"; 60'"; 70; 70') by molding.

15. The method for manufacturing a molded power package (300) according to claim 14, wherein a first molding material of the mold compound pattern portion (40p; 40p'"; 740p; 740p') is different from a second molding material used in the step of encapsulating the at least one of the plural power semiconductor devices (60; 60'; 60"; 60'"; 70; 70') by molding.
